(19) Europäisches Patentamt
European Patent Office
Office européen des brevets

(11) **EP 1 741 162 B1**

(12) **EUROPÄISCHE PATENTSCHRIFT**

(45) Veröffentlichungstag und Bekanntmachung des Hinweises auf die Patenterteilung:
**29.12.2010 Patentblatt 2010/52**

(21) Anmeldenummer: **05743512.5**

(22) Anmeldetag: **26.04.2005**

(51) Int Cl.:
***H01R 4/48*** *(2006.01)*

(86) Internationale Anmeldenummer:
**PCT/DE2005/000767**

(87) Internationale Veröffentlichungsnummer:
**WO 2005/104256 (03.11.2005 Gazette 2005/44)**

(54) **ELEKTRISCHE FUNKTIONSEINHEIT UND VERFAHREN ZU DEREN HERSTELLUNG**

ELECTRIC FUNCTIONAL UNIT AND METHOD FOR THE PRODUCTION THEREOF

UNITE FONCTIONNELLE ELECTRIQUE ET PROCEDE POUR SA PRODUCTION

(84) Benannte Vertragsstaaten:
**DE FR GB**

(30) Priorität: **26.04.2004 DE 102004020329**

(43) Veröffentlichungstag der Anmeldung:
**10.01.2007 Patentblatt 2007/02**

(73) Patentinhaber: **EPCOS AG**
**81669 München (DE)**

(72) Erfinder:
• **FLORIAN, Heinz**
  **A-8524 Bad Gams (AT)**

• **VOGL, Wolfgang**
  **A-1160 Wien (AT)**
• **KARTASHEV, Igor**
  **A-8530 Deutschlandsberg (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**WO-A-03/094252    US-A- 3 548 347**
**US-A- 4 471 256**

**Beschreibung**

Die Erfindung betrifft eine elektrische Funktionseinheit mit einem Körper, der gebildet ist aus einem Stapel von übereinanderliegenden keramischen Schichten.

Aus der Druckschrift WO03/094252A ist ein Piezoaktor bekannt mit einem Grundkörper, der einen Stapel von übereinanderliegenden piezo-elektrischen Schichten und dazwischenliegenden Elektrodenschichten enthält, bei dem die piezo-elektrischen Schichten Keramikmaterial enthalten und mit den Elektrodenschichten versintert sind. Senkrecht zu den Elektrodenschichten verläuft ein Loch durch den Grundkörper, in das ein Stift eingeschoben ist.

Aus der Druckschrift JP03151677A ist eine elektrische Funktionseinheit der eingangs genannten Art bekannt, bei der interne Elektroden eines piezo-elektrischen Aktors durch ein elastisches Element kontaktiert werden, wobei das elastische Element der Bewegung des Piezoaktors beim Betrieb folgen kann.

Aus der Druckschrift US 4,471,256 A ist eine elektrische Funktionseinheit der eingangs genannten Art bekannt, die eine Kontaktvorrichtung mit Federelement aufweist.

Es ist Aufgabe der vorliegenden Erfindung, eine elektrische Funktionseinheit anzugeben, bei der die elektrische Kontaktierung in zuverlässiger Art und Weise erfolgt.

Diese Aufgabe wird gelöst durch eine Funktionseinheit nach Patentanspruch 1. Vorteilhafte Ausgestaltungen der Funktionseinheit und ein Verfahren zur Herstellung der Funktionseinheit sind Gegenstand der weiteren Patentansprüche.

Es wird eine elektrische Funktionseinheit angegeben, die einen Körper aufweist. Der Körper ist gebildet aus einem Stapel von übereinanderliegenden keramischen Schichten.

Die keramischen Schichten können beispielsweise Schichten mit piezo-elektrischen Eigenschaften sein. In diesem Fall kann die elektrische Funktionseinheit ein Piezoaktor sein. Vorzugsweise werden in diesem Fall zwischen den keramischen Schichten noch Elektrodenschichten angeordnet, die nach außen hin kontaktiert werden, sodass eine elektrische Spannung an einen Kondensator angelegt werden kann, dessen Dielektrikum mit einem piezo-elektrischen Material gefüllt ist.

Die elektrische Funktionseinheit weist einen Hohlraum auf, der im Körper liegt und der von außen zugänglich ist. Der Hohlraum weist eine Wand auf, an der eine Kontaktfläche angeordnet ist. Die Kontaktfläche ist vorzugsweise elektrisch leitend verbunden mit einem elektrischen Funktionselement. Ein solches elektrisches Funktionselement kann beispielsweise eine Elektrodenschicht eines Vielschicht-Piezoaktors sein.

Die elektrische Funktionseinheit weist eine Kontaktvorrichtung zur Kontaktierung der Kontaktfläche auf. Die Kontaktvorrichtung ist ferner von außerhalb des Körpers anschließbar. Beispielsweise können Kontaktdrähte von außen an die Kontaktvorrichtung angelötet oder anderweitig elektrisch leitend befestigt werden.

Die Kontaktvorrichtung umfasst eine Kontaktfeder, die auf die Kontaktfläche eine Federkraft ausübt.

Durch die Kontaktfeder wird der elektrische Kontakt zwischen der Kontaktvorrichtung und der Kontaktfläche vermittelt.

Die vorliegende Erfindung macht sich ein Konzept zunutze, wonach die Kontaktierung einer Kontaktfläche im Inneren des Körpers erfolgt. Dadurch ist die Kontaktierung von störenden äußeren Einflüssen, beispielsweise mechanischen Einflüssen, entkoppelt. Darüber hinaus kann der Vorteil erzielt werden, dass durch Integration der Kontaktvorrichtung ins Innere des Körpers Platz eingespart werden kann.

Darüber hinaus bleibt im Gegensatz zu einer Kontaktierung von außen für weitere notwendige Elemente, beispielsweise für eine Kühlvorrichtung Platz an der Außenseite des Körpers.

Indem ferner die Kontaktierung über eine Kontaktfeder erfolgt, ist die Kontaktierung unempfindlich gegenüber mechanischen Einflüssen, wie sie beispielsweise bei der Kontraktion bzw. bei der Ausdehnung in Längsrichtung eines piezo-elektrischen Aktors erfolgt.

Insbesondere ist die hier beschriebene Art der Kontaktierung vorteilhaft bei bewegten Bauteilen, wie beispielsweise Piezo-Stacks, einzusetzen.

Besonders vorteilhaft ist es, wenn die Kontaktvorrichtung verschiebbar in dem Hohlraum des Körpers angeordnet ist. Dadurch kann die Kontaktvorrichtung als Ganzes verschoben werden, um beispielsweise auf mechanische äußere oder innere Einflüsse zu reagieren. Beispielsweise kann bei nachlassendem elektrischen Kontakt nach vielen Betriebsstunden der elektrischen Funktionseinheit durch Herausziehen der Kontaktvorrichtung eine einfache Wartung des elektrischen Kontakts erfolgen.

Die Kontaktvorrichtung ist in den Hohlraum eingeschoben. Dies hat den Vorteil, dass die Schritte zur Herstellung des Körpers und die Schritte zur Herstellung des elektrischen Kontakts zeitlich und auch örtlich voneinander getrennt werden können. Dadurch können beispielsweise Materialien für die elektrische Kontaktvorrichtung verwendet werden, die nicht kompatibel sein müssen mit den Verfahrensschritten, die zur Herstellung des Körpers bzw. der elektrischen Funktionseinheit angewendet werden.

Darüber hinaus ist es vorteilhaft, wenn die Kontaktvorrichtung einschiebbar ist. Sie muss nicht notwendigerweise verschiebbar sein. Vielmehr genügt es auch, um den oben genannten Vorteil zu erzielen, wenn die Kontaktvorrichtung einmalig eingeschoben werden kann und dann beispielsweise durch eine Verrastung im Körper verbleibt. Sie muss nicht zu jeder Zeit im Körper bzw. in dem Hohlraum verschiebbar sein.

Darüber hinaus sind eine oder mehrere Kontaktfedern vorgesehen, die den elektrischen Kontakt zur Kontaktfläche vermitteln, wodurch es möglich ist, dass die Kontaktvorrichtung von außerhalb des Körpers elektrisch anschließbar bzw. kontaktierbar ist.

In einer Ausführungsform der Funktionseinheit ist es vorgesehen, dass die Kontaktfläche mit einem im Innern des Körpers angeordneten elektrisch leitenden Funktionselement verbunden ist. Mit Hilfe einer solchen Ausführungsform kann ein elektrisches Funktionselement im Innern des Körpers mit Hilfe der Kontaktvorrichtung von außen kontaktiert werden.

In einer anderen Ausführungsform der Funktionseinheit ist es vorgesehen, dass die Kontaktfläche gebildet ist durch eine Abdeckung, die die Wand des Hohlraums wenigstens teilweise bedeckt. Es muss nicht notwendigerweise die gesamte Wand des Hohlraums bedeckt sein. Es genügt, wenn an bestimmten, zur Kontaktierung vorgesehenen Stellen eine Bedeckung der Wand des Hohlraums vorgesehen ist. In einer anderen Ausführungsform der Funktionseinheit kann auch die gesamte Wand des Hohlraums mit einer Abdeckung bedeckt sein. Die Abdeckung besteht vorzugsweise durchgängig aus elektrisch leitfähigem Material, dies ist jedoch nicht unbedingt erforderlich. Es genügt, wenn die Abdeckung an dafür vorgesehenen Stellen elektrisch leitfähig ist, um einen Kontakt zur Kontaktvorrichtung vermitteln zu können.

Die Kontaktvorrichtung der elektrischen Funktionseinheit weist ein aus dem Hohlraum herausragendes Anschlussteil auf. Dieses Anschlussteil ist elektrisch leitend mit der Kontaktfeder verbunden. Ferner ist das Anschlussteil von außen weiter kontaktierbar, beispielsweise durch Anklemmen oder Anlöten eines elektrisch leitenden Drahts. Mit Hilfe des nach außen herausragenden Anschlussteils kann eine funktionale Trennung zwischen federnder elektrischer Kontakt und von außen kontaktierbar erzielt werden. Dies hat den Vorteil, dass jede der beiden Funktionen hinsichtlich der zu wählenden Form des die Funktion erfüllenden Elements als auch hinsichtlich der zu wählenden Materialien optimiert werden kann.

Dies bedeutet jedoch nicht, dass die beiden Funktionen notwendigerweise in getrennten Elementen realisiert sein müssen. Es gibt Ausführungsformen der Funktionseinheit, bei denen die Kontaktfeder gleichzeitig der äußeren Kontaktierung dient.

In einer Ausführungsform der Funktionseinheit ist die Abdeckung gebildet durch ein metallisches Blech. Dieses metallische Blech kann beispielsweise die Form eines Rohres haben und dabei die Wand eines lochförmigen Hohlraums im Körper bedecken.

In einer anderen Ausführungsform der Funktionseinheit wird die Abdeckung gebildet durch eine metallhaltige Einbrennpaste. Diese Einbrennpaste kann beispielsweise auf die Wand des Lochs aufgestrichen und anschließend bei einer geeigneten Temperatur auf die Wandoberfläche eingebrannt werden.

In einer anderen Ausführungsform der Funktionseinheit ist eine Abdeckung in Form eines Leitklebers vorgesehen. Der Leitkleber kann beispielsweise mittels eines Pinsels auf die Wand des Hohlraums aufgetragen werden.

In einer anderen Ausführungsform der Funktionseinheit ist es vorgesehen, dass die Abdeckung gebildet wird durch einen schraubenförmig gewendelten Draht. Dabei kann es sich um einen runden Draht oder auch um einen Draht mit rechteckigem Querschnitt handeln.

In einer Ausführungsform der Funktionseinheit ist es vorgesehen, dass die Kontaktvorrichtung gebildet ist durch ein in Längsrichtung geschlitztes, federndes Rohr. Diese Ausführungsform hat den Vorteil, dass die Funktion federnder Kontakt zur Kontaktfläche und die Funktion von außen kontaktierbar mit einem einzigen Element, nämlich mit dem federnden Rohr, erzielt werden können. Dadurch hat die Funktionseinheit einen besonders einfachen und kompakten Aufbau.

In einer anderen Ausführungsform der Funktionseinheit ist es vorgesehen, dass ein separates Anschlussteil Teil der Kontaktvorrichtung ist. Dieses Anschlussteil kann beispielsweise ein Metallstift sein. Das Anschlussteil kann aber auch gebildet werden durch miteinander verdrillte Drähte.

In einer anderen Ausführungsform der Funktionseinheit ist ein Federteil vorgesehen, das die Form eines gebogenen, federnden Bleches hat.

In einer anderen Ausführungsform kann das Federteil gebildet sein durch ein Rohr mit einer gewellten Wand. Durch die wellenförmig verlaufende Wand kann eine Federkraft zwischen dem Federteil und der Kontaktfläche erzeugt werden.

In einer anderen Ausführungsform der Funktionseinheit kann das Federteil gebildet sein durch die Borsten einer Rohrbürste. Insbesondere kommen in Betracht metallische bzw. elektrisch leitende Borsten, die beispielsweise an miteinander verdrillten Drähten befestigt sind.

In einer anderen Ausführungsform der Funktionseinheit kann das Federteil die Form eines Drahtgeflechtes haben.

In einer Ausführungsform der Funktionseinheit ist eine Vielzahl von elektrischen Funktionselementen vorgesehen, wobei diese Funktionselemente in Form von elektrisch leitenden Elektrodenschichten, die zwischen den keramischen Schichten angeordnet sind, gebildet sind.

Mit Hilfe solcher Funktionselemente kann beispielsweise ein Piezoaktor als elektrische Funktionseinheit realisiert werden.

In einer anderen Ausführungsform kann es vorgesehen sein, dass die Abdeckung in den Hohlraum eingesintert ist. Dadurch entsteht vorteilhafterweise eine feste mechanische Verbindung zwischen dem Körper und der Abdeckung, sodass insbesondere bei Kontraktions- bzw. Ausdehnungsbewegungen des Körpers die Gefahr der Ablösung der Abdeckung reduziert ist.

In einer besonderen Ausführungsform der Funktionseinheit ist es vorgesehen, dass die Funktionseinheit beim Betrieb mechanische Spannungen erzeugt. Diese mechanischen Spannungen können beispielsweise Kontraktionen bzw. Ausdehnungen in einer Längsrichtung sein.

In einer anderen Ausführungsform der Funktionseinheit ist der Hohlraum gestaltet in Form eines im Körper verlaufenden Loches. Die Abdeckung kann in diesem Fall vorzugsweise die Form eines Rohres haben, das an das Loch angepasst ist. In einer speziellen Ausführungsform ist der Körper der Funktionseinheit durch gemeinsames Sintern mehrerer übereinanderliegender keramischer Grünfolien hergestellt, wobei durch eine geeignete Anpassung der Länge des Rohres und des äußeren Durchmessers des Rohres eine feste Einsinterung des Rohres in das Loch erzielt werden kann.

In einer besonderen Ausführungsform kann es vorgesehen sein, dass das Rohr durch sinterschrumpfbedingte Kräfte, die zum Lochinneren gerichtet sind, in dem Loch gehalten ist.

Des Weiteren ist es vorteilhaft, wenn das Material des Rohres gleich dem Material der Elektrodenschichten ist. In diesem Fall kann die Materialvielfalt reduziert werden und darüber hinaus kann eine besonders gute elektrisch leitende Anbindung des Rohres an die Elektrodenschichten des Vielschichtbauelements erzielt werden.

In einer besonderen Ausführungsform der Funktionseinheit kann das Rohr ein geschlitztes, ein poröses, ein gelochtes oder auch ein mit Dellen versehenes Rohr sein.

Es wird darüber hinaus ein Verfahren zur Herstellung einer zuvor beschriebenen elektrischen Funktionseinheit angegeben, wobei ein Stapel von übereinanderliegenden keramischen Grünfolien gebildet wird. Zwischen den Grünfolien sind Elektrodenschichten angeordnet.

Der so gebildete Stapel weist ein Loch auf.

In das Loch wird eine Abdeckung eingeführt.

Die Abdeckung kann beispielsweise in das Loch eingeschoben oder auch hineingedrückt werden.

Anschließend wird der Stapel gemeinsam mit der Abdeckung gesintert.

In einer besonderen Ausführungsform des Verfahrens wird eine Vielzahl von keramischen Grünfolien bereitgestellt, die mit gestanzten Durchbrüchen versehen sind.

Anschließend werden die Grünfolien so übereinandergestapelt, dass die Durchbrüche deckungsgleich übereinander zu liegen kommen. Durch die übereinanderliegenden Durchbrüche kann dann das Loch in dem Körper gebildet werden.

In einer anderen Variante des hier beschriebenen Verfahrens werden keramische Grünfolien übereinandergestapelt, wobei die Grünfolien jedoch vorzugsweise von Durchbrüchen frei sind. Anschließend wird in den so gebildeten grünen Stapel ein Loch gebohrt. In dieses Loch kann dann die Abdeckung, beispielsweise in Form eines Rohres, eingeschoben werden.

In einer anderen Ausführungsform des Verfahrens wird als Abdeckung ein Rohr verwendet, dessen laterale, quer zur Längsrichtung des Rohres zu messende Ausdehnung so gewählt wird, dass das Rohr durch Schrumpfen des Lochs während des Sinterns der keramischen Grünfolien im Loch gehalten wird.

Dadurch entsteht eine gute mechanische Verbindung zwischen der Rohraußenwand und dem Keramikmaterial bzw. eine gute elektrische Verbindung zwischen dem Rohr und den Innenelektroden.

Im Folgenden wird eine elektrische Funktionseinheit anhand von Ausführungsbeispielen und den dazu gehörigen Figuren näher erläutert.

Figur 1 zeigt beispielhaft eine erfindungsgemäße Funktionseinheit in einem schematischen Querschnitt.

Figur 2 zeigt eine elektrische Funktionseinheit in einem schematischen Querschnitt, wobei Elektrodenschichten innerhalb des Körpers vorgesehen sind.

Figur 2A zeigt die Anbindung von Innenelektroden an der Innenseite des Lochs.

Figur 3 zeigt eine nicht erfindungsgemäße Kontaktvorrichtung und eine zugehörige Abdeckung.

Figur 4 zeigt in einer perspektivischen Darstellung eine weitere beispielhafte Abdeckung.

Figur 5 zeigt die perspektivische Darstellung einer Kontaktfeder.

Figur 6 zeigt die Anordnung zweier Kontaktfedern gemäß Figur 5 in einem Loch eines Körpers.

Figur 7 zeigt die Anordnung aus Figur 6 mit einem zusätzlichen Anschlussteil.

Figur 8 zeigt eine Kontaktfeder in Form eines gewellten Rohres.

Figur 9 zeigt die Kontaktfeder aus Figur 8 zusammen mit einem Anschlussteil und einer Abdeckung.

Figur 10 zeigt in jeweils schematischen Querschnitten drei verschiedene Ausführungsformen für Kontaktfedern in Form von gewellten Rohren.

Dabei sind gleiche Elemente bzw. Elemente, die die gleiche Funktion ausüben, mit gleichen Bezugszeichen bezeichnet.

Figur 11 zeigt eine weitere elektrische Funktionseinheit in einem schematischen Querschnitt, wobei als Kontaktfeder ein Drahtgeflecht vorgesehen ist.

Figur 12 zeigt eine perspektivische Darstellung einer Funktionseinheit mit einem Drahtgeflecht als Kontaktfeder.

Figur 13 zeigt in einem schematischen Querschnitt beispielhaft eine elektrische Funktionseinheit, wobei als Kontaktfeder eine Vielzahl von Borsten vorgesehen ist.

Figur 14 zeigt in einer perspektivischen Darstellung eine elektrische Funktionseinheit mit zwei Hohlräumen, die jeweils durch elektrisch leitende Borsten kontaktiert werden.

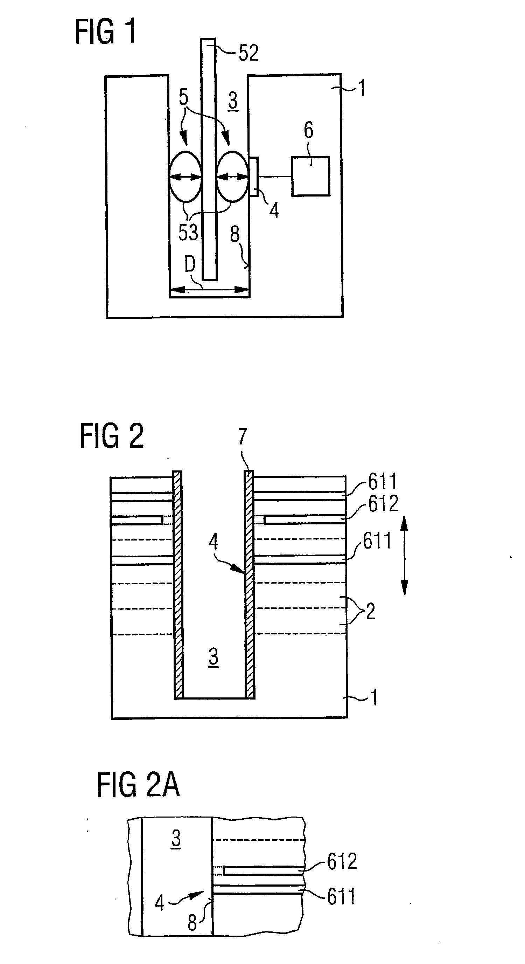

Figur 1 zeigt einen Körper 1, der mit einem Hohlraum 3 versehen ist. Der Hohlraum ist von außen zugänglich und im Beispiel von Figur 1 in Form eines Loches bzw. eines Sackloches ausgeführt. Der Hohlraum 3 ist nicht auf die Lochform begrenzt, sondern kann beliebige verschiedene Formen haben. Der Hohlraum 3 muss auch nicht durch den Körper 1 durchgehen. Entscheidend ist lediglich, dass der Hohlraum 3 von außen zugänglich ist.

Im Körper 1 ist eine elektrische Kontaktfläche 4 vorgesehen, die an der Oberfläche der Wand 8 des Hohlraums 3 anliegt. Vorzugsweise ist die Kontaktfläche 4 elektrisch leitend verbunden mit einem elektrischen Funktionselement 6. Um das Funktionselement 6 von außen kontaktieren zu können, ist eine Kontaktvorrichtung 5 vorgesehen. Die Kontaktvorrichtung 5 besteht aus einem Anschlussteil 52, das sich in Längsrichtung im Hohlraum 3 erstreckt und von außen zugänglich ist. Das Anschlussteil 52 ragt aus dem Hohlraum 3 heraus. Es sind ferner als Bestandteil der Kontaktvorrichtung 5 noch Kontaktfedern 53 vorgesehen, die im Inneren des Hohlraums 3 zusammengedrückt sind und dementsprechend Kräfte auf das Anschlussteil 52 bzw. auf die Wand 8 des Hohlraums 3 ausüben, wie sie durch die beiden Doppelpfeile angedeutet sind. Es werden also von den Kontaktfedern 53 Druckkräfte, die vom Inneren der Kontaktfedern 53 nach außen wirken, ausgeübt. Durch diese Druckkräfte kann ein elektrischer Kontakt zwischen der Kontaktfläche 4 und dem Anschlussteil 52 vermittelt werden. Die Kontaktierung findet dabei statt zum einen an dem Punkt, wo die Kontaktfeder 53 die Kontaktfläche 4 mit Druck berührt. Ferner findet der Kontakt statt an der Stelle, wo die Kontaktfeder 53 mit dem Anschlussteil 52 verbunden ist.

Figur 2 zeigt eine weitere Ausführungsform für die elektrische Funktionseinheit. Der Körper 1 ist gebildet durch einen Stapel von übereinanderliegenden keramischen Schichten 2. An einigen Stellen sind zwischen zwei keramischen Schichten 2 Elektrodenschichten 611 einer ersten Sorte oder Elektrodenschichten 612 einer zweiten Sorte angeordnet. Durch eine solche Anordnung kann beispielsweise ein piezo-elektrischer Aktor gebildet werden. Dabei werden auf ein erstes Potenzial alle Elektrodenschichten 611 der ersten Sorte gelegt. Auf ein anderes Potenzial werden alle Elektrodenschichten 612 der zweiten Sorte gelegt. Dadurch werden die piezo-elektrischen Schichten 2 einem elektrischen Feld ausgesetzt, was zu einer Expansion dieser Schichten und zu einer Ausdehnung des Körpers 1 in dessen Längsrichtung führt.

Die Kontaktierung der Elektrodenschichten 611, 612 kann beispielsweise durch zwei Hohlräume 3 vorgenommen werden. Beispielhaft ist in Figur 2 eine solche Art der Kontaktierung dargestellt. In Längsrichtung des Körpers 1 ist ein Hohlraum 3 in Form eines Loches vorgesehen. Die Wand 8 des Loches ist mit einer Abdeckung 7 versehen, die beispielsweise die Form eines elektrisch leitenden, metallischen Rohres haben kann. Die Innenfläche der Abdeckung 7 bildet dann die Kontaktfläche 4.

Dabei ist es vorteilhaft, wenn das Loch über die gesamte Länge des Körpers 1 verläuft, so dass alle Elektrodenschichten 611 der ersten Sorte von einer Kontaktvorrichtung kontaktiert werden kann.

Die Abdeckung 7 kann beispielsweise in den Hohlraum 3 eingesintert sein. Dadurch entsteht ein guter elektrischer Kontakt zwischen der Abdeckung 7 und den Elektrodenschichten 611 der ersten Sorte. Die Elektrodenschichten 612 der zweiten Sorte sind so gestaltet, dass sie zur Abdeckung 7 einen ausreichenden Abstand haben, sodass hier ein elektrischer Kontakt und mithin ein Kurzschluss zwischen den beiden unterschiedlichen elektrischen Polen vermieden werden kann. Des Weiteren kann durch das Einsintern der Abdeckung 7 in den Hohlraum 3 eine gute mechanische Anbindung der Abdeckung 7 an die keramischen Schichten 2 und mithin an den Körper 1 bewerkstelligt werden.

Figur 2 wäre dann durch eine geeignete Kontaktvorrichtung 5 zu ergänzen, um die Kontaktierung der Elektrodenschichten 611 zu vervollständigen.

Die Abdeckung 7 kann beispielsweise in Form eines Rohres, beispielsweise eines Kupferrohres, ausgebildet sein. Das Kupferrohr kann einen Innendurchmesser von 1,2 mm haben. Das Kupferrohr hat entsprechend der Ausdehnung des Körpers 1 eine Länge von etwa 30 mm. Falls eine größere Anzahl von keramischen Schichten 2 und entsprechend Elektrodenschichten 611, 612 vorgesehen ist, beispielsweise um eine besonders große Auslenkung des Piezoaktors zu erreichen, sind auch Kupferrohre mit einer Länge von 60 mm oder sogar darüber denkbar. Vorzugsweise wird das Material der Abdeckung 7 so gewählt, dass es dem Material der Elektrodenschichten 611, 612 entspricht. Als Material für die Elektrodenschichten kommt beispielsweise Kupfer oder auch Silber-Palladium in Betracht. Dementsprechend können dieselben Materialien auch für die Abdeckung 7 verwendet werden.

In Figur 2 ist noch die Bewegung des Aktors in dessen Längsrichtung bei Anlegen einer elektrischen Spannung an die Elektrodenschichten gezeigt. Der Aktor dehnt sich in Längsrichtung aus bei Anlegung der Spannung, bei Wegnehmen der Spannung zieht er sich in Längsrichtung zusammen.

Figur 2A zeigt eine weitere Variante, um die Elektrodenschichten 611 zu kontaktieren. In dieser Variante wird keine Abdeckung 7 verwendet. Die Elektrodenschichten 611 reichen jedoch bis an die Wand 8 des Hohlraums 3. Dort bilden sie eine freie Oberfläche und mithin eine Kontaktfläche 4. Diese Kontaktfläche kann dann durch eine geeignete Kontaktvorrichtung, beispielsweise gemäß Figur 1, kontaktiert werden.

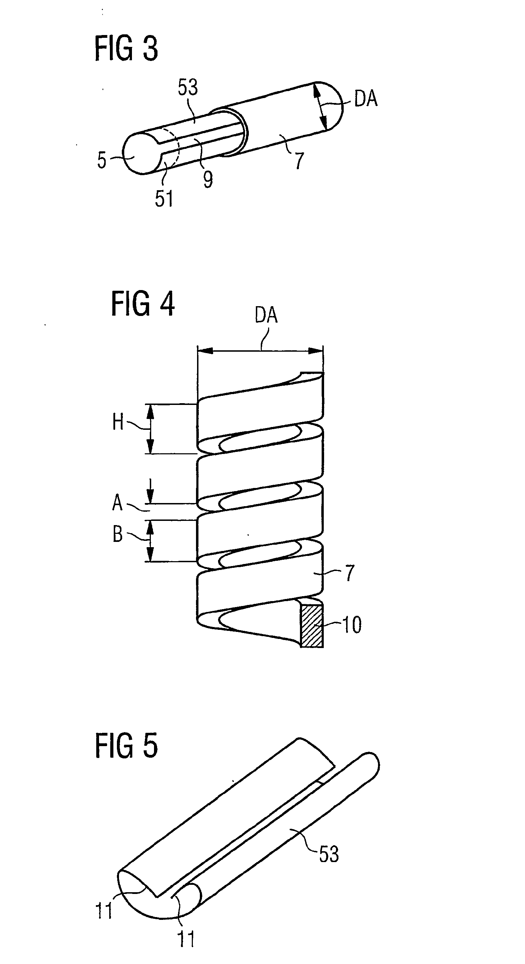

Figur 3 zeigt eine nicht erfindungsgemäße Kontaktvorrichtung 5 in Form eines Rohres, welches in Längsrichtung aufgeschlitzt ist. Ein solches Rohr kann geeignet aufgebogen werden, sodass es bei Einschieben in eine Abdeckung 7, die ihrerseits die Form eines Rohres hat, eine entsprechende elastische Kraft, die von innen nach außen wirkt, auf die Innenwand der Abdeckung 7 ausübt. Insofern bildet das geschlitzte Rohr die Kontaktfeder 53. Indem das geschlitzte Rohr nicht ganz in die Abdeckung 7 bzw. in das die Abdeckung 7 bildende Rohr eingeschoben wird, bleibt ein Überstand außerhalb der Abdeckung 7 stehen, der auch außerhalb eines Körpers 1 stehen bleiben kann und der somit einen Anschlussabschnitt 51 der Kontaktvorrichtung 5 bilden kann.

Die Kontaktvorrichtung 5 in Figur 3 weist einen Längsschlitz 9 auf.

In Figur 3 ist noch eine Abdeckung 7 in Form eines Rohres gezeigt. Die laterale Ausdehnung DA des Rohres ist dabei ebenfalls angedeutet. Sie entspricht bei einem zylindrischen Rohr dem Außendurchmesser des Rohres. Dieser Außendurchmesser kann nun in Bezug auf das Loch, insbesondere in Bezug auf den Lochdurchmesser D, wie er beispielsweise in Figur 1 gezeigt ist, so gewählt werden, dass die Abdeckung 7 beim Einsintern in den Hohlraum in Form eines Loches durch die Sinterkräfte gehalten wird. Beispielsweise kann ein Loch in einem Grünkörper aus übereinandergestapelten keramischen Grünfolien mit einem Durchmesser von 1,5 mm gebildet werden. Bei der Wahl eines Rohres mit einem Außendurchmesser von 1,4 mm kann dafür gesorgt werden, dass nach dem Sintern des Körpers das Rohr in dem Loch festgehalten ist.

Dies wird bewirkt durch den Sinterschrumpf, der in Richtung auf die Mitte des Hohlraums wirkt.

Figur 4 zeigt eine Abdeckung 7 in Form eines schraubenartig gewendelten Drahtes. Es handelt sich bei dem Draht um einen Flachdraht 10.

Die in Figur 4 dargestellte Wendel ist charakterisiert durch die laterale Ausdehnung DA der Abdeckung 7, durch die Steigung H der Wendel, durch die Öffnung A der Wendel und durch die Breite B der Wendel, wobei die Breite B im Falle eines Runddrahtes dem Durchmesser des Runddrahtes entspräche.

Es gilt hierbei:

$$B + A = H.$$

Bei der Herstellung eines Körpers 1 in Form eines Stapels von übereinanderliegenden keramischen Grünfolien kann beim Sintern in Längsrichtung, d. h. in Stapelrichtung, beispielsweise eine relative Längenänderung L : L0 = 0,84 erzielt werden. Hierbei steht L für die Länge des Stapels nach dem Sintern und L0 für die Länge des Stapels vor dem Sintern. Durch eine geeignete Wahl der Parameter der Wendel kann erreicht werden, dass die Öffnungen der Wendel während des Sinterns geschlossen werden und gleichzeitig die Wendel dem Schrumpfen keinen Widerstand entgegensetzt, da sie ja durch Schließen der Öffnungen dem Sinterschwund nachgibt. Eine geeignete Wahl der Wendelparameter bestünde darin, dass festgelegt wird:

$$\frac{B}{A} = \frac{L}{L0},$$

was gleichbedeutend ist mit:

$$\frac{B}{A+B} = \frac{L}{L0}.$$

Figur 5 zeigt eine weitere Ausführungsform einer Kontaktfeder 53, die in Form eines geschlitzten Rohres gebildet ist, wobei seitlich nach innen zum Rohr zwei Laschen 11 nach innen gebogen sind. Durch diese Laschen kann im Wesentlichen eine Federkraft entstehen.

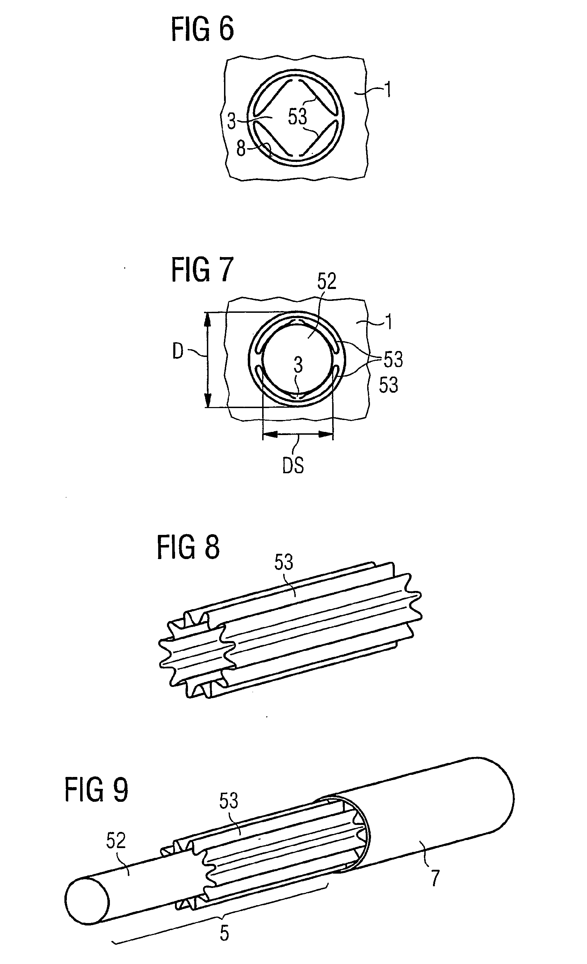

Figur 6 zeigt, wie zwei der Kontaktfedern gemäß Figur 5 im Inneren eines kreisförmigen Hohlraums 3 anzuordnen sind, um eine gute, flächige Kontaktierung der Wand 8 des Hohlraums 3 zu gewährleisten.

Figur 7 zeigt einen weiteren Schritt zur Vervollständigung der Kontaktvorrichtung 5. Zwischen den beiden Kontaktfedern 53 ist nun noch ein Anschlussteil 52 mittig eingeschoben, wodurch die Laschen der Kontaktfedern 53 nach außen gebogen werden und wodurch letztlich ausreichende Federkräfte entstehen, die einen elektrischen Kontakt zwischen dem Anschlussteil 52 und den an der Wand 8 angeordneten Kontaktflächen vermitteln. Die von den Kontaktfedern 53 erzeugten Federkräfte sind im Prinzip genauso gerichtet, wie sie in Figur 1 dargestellt sind.

Das in Figur 7 gezeigte Loch, das den Hohlraum 3 bildet, ist kreisförmig im Querschnitt und hat einen Durchmesser D von etwa 1,2 mm. Durch das Einschieben eines Anschlussteils 52 in Form eines zentralen Stiftes mit einem Außendurchmesser DS von 0,6 bis 0,8 mm kann mit Hilfe der Kontaktfedern 53 eine ausreichende radial gerichtete Federkraft aufgebracht werden.

Figur 8 zeigt eine weitere Ausführungsform einer Kontaktfeder 53 in Form eines gewellten Rohres.

Allgemein für die hier beschriebenen Kontaktfedern gilt, dass sie vorzugsweise aus einem federnden Material, beispielsweise Beryllium-Bronze, Kupfer-Bronze oder einem ähnlichen geeigneten, elektrisch leitenden Material gefertigt sind.

Die Kontaktfedern, die hier beschrieben sind, üben radiale, federnde Kräfte aus, die zwischen der Wand 8 des Hohlraums 3 und einem Anschlussteil 52 bzw. der Kontaktfeder selbst wirken.

Durch die gewellte Oberfläche des Rohres in Figur 8 kann ebenfalls bei passender Geometrie, d. h. bei einem geeigneten Durchmesser des Lochs, in das die Kontaktfeder 53 eingeschoben wird, die Bildung von radialen Federkräften erzeugt werden.

Dies ist beispielhaft in Figur 9 gezeigt, wo eine Abdeckung in Form eines Rohres entsprechend Figur 3 gezeigt ist. In diese Abdeckung ist eine Kontaktfeder 53 gemäß Figur 8 eingeschoben, wobei die geometrischen Verhältnisse so gewählt sind, dass die gewählte Oberfläche der Kontaktfeder 53 eine radiale Federkraft ausübt. Zur weiteren Kontaktierung ist in den mittleren Bereich der Kontaktfeder 53 ein Anschlussteil 52 in Form eines metallisch leitenden Stiftes eingeschoben.

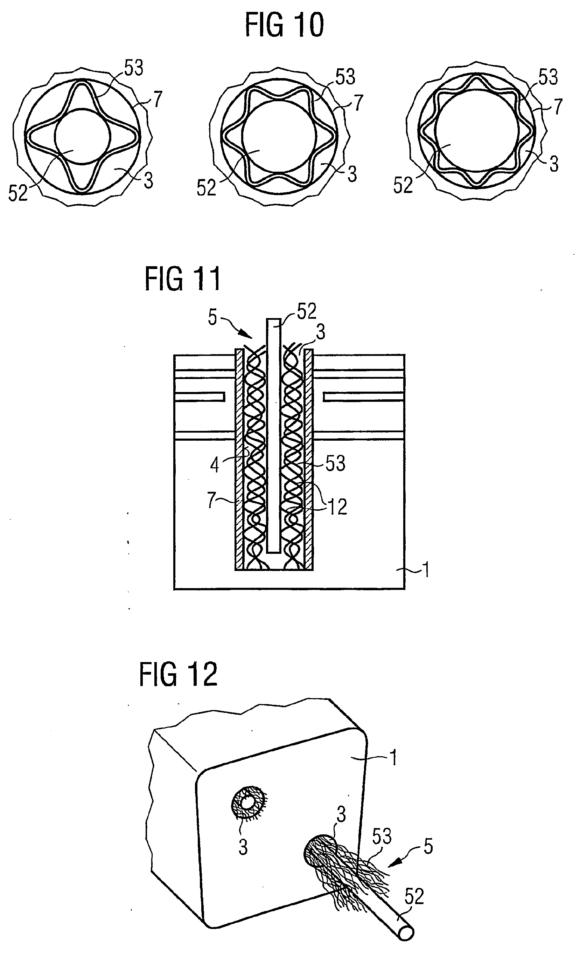

Figur 10 zeigt in einem Querschnitt drei verschiedene Varianten für die Ausgestaltung der Kontaktfeder 53 nach dem Beispiel aus Figur 8. Die Darstellungen von Figur 10 von links nach rechts betrachtet kann die Kontaktfeder im Querschnitt betrachtet entsprechend einer vierzähligen, sechszähligen oder auch einer achtzähligen Symmetrie gebildet sein. Entsprechend der Formgebung der Kontaktfeder 53 muss bei gegebenen Abmessungen der Abdeckung 7 das Anschlussteil 52, d. h. der zentrale Stift aus Figur 9, seinem Durchmesser nach der Gestaltung der Kontaktfeder angepasst werden. Der Durchmesser des Anschlussteils 52 nimmt von links nach rechts zu.

Figur 11 zeigt eine weitere Ausführungsform einer elektrischen Funktionseinheit, wobei als Kontaktfeder 53 ein Drahtgeflecht vorgesehen ist. Entsprechend den Figuren 7, 9 und 10 ist in der Mitte des Hohlraums 3 wieder ein Anschlussteil 52 in Form eines zentralen Stifts zur Herausführung des Kontakts nach außen vorgesehen. Im Übrigen entspricht der Aufbau des Bauteils nach Figur 11 der Figur 2.

Die Kontaktfeder 53 in Form eines gewellten Rohres kann auch als Wellblechrohr beschrieben werden.

Beim Einschieben des Kontaktteils 13 zusammen mit den verflochtenen Litzen 13 entsteht durch Zusammendrücken der Litzen 12 eine radial gerichtete Federkraft, wodurch die Litzen 12 bzw. die verflochtenen Litzen 12 die Funktion der Kontaktfeder 53 übernehmen.

Figur 12 zeigt ein Bauelement, bei dem die Kontaktvorrichtung entsprechend Figur 11 gebildet ist. Das Drahtgeflecht, das die Kontaktfeder 53 bildet, ist, wie aus Figur 12 zu erkennen ist, in Form einer Litze, wie sie beispielsweise zum Abschirmen von Leitungen verwendet wird, ausgebildet. Figur 12 zeigt zwei Hohlräume 3, wobei bei dem ersten Hohlraum die Litze ganz in den Hohlraum eingeschoben ist und beim zweiten Hohlraum gerade der Vorgang des Einschiebens von Kontaktfeder 53 und Anschlussteil 52 in den Hohlraum 3 gezeigt ist.

Das in Figur 11 und Figur 12 beschriebene Drahtgeflecht kann hergestellt werden durch Verflechten einzelner dünner Litzen 12 miteinander.

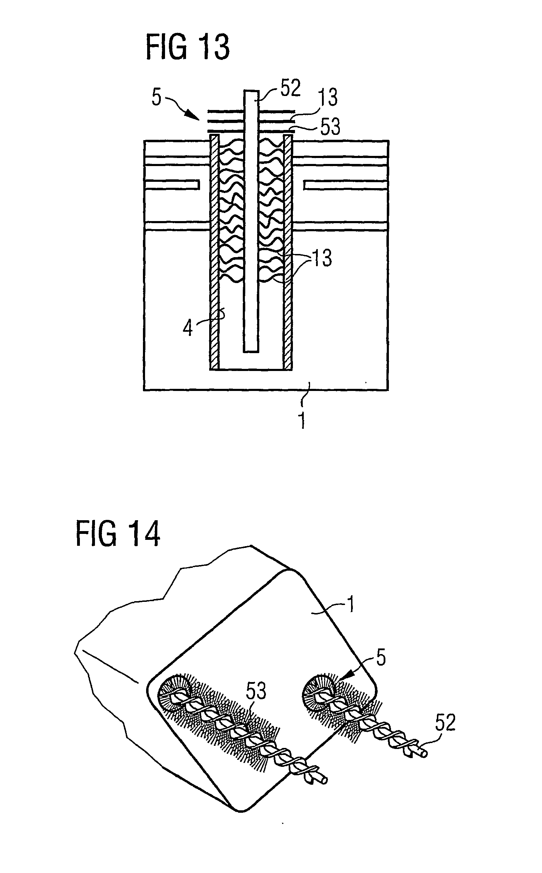

Figur 13 zeigt eine weitere Ausführungsform der Kontaktvorrichtung, wobei die Kontaktfeder 53 gebildet ist aus einer Vielzahl kleiner Borsten 13, die an einem Anschlussteil 52 befestigt sind.

In Figur 13 ist gezeigt, wie die Borsten 13, die an einem Anschlussteil 52 befestigt sind, in ihrer Länge so gewählt sind, dass sie sich beim Einschieben in den Hohlraum 13 verformen müssen und so eine radial gerichtete Federkraft ausüben. Damit ist gezeigt, dass die Borsten 13 die Funktion der Kontaktfeder 53 übernehmen können. Die Borsten 13 bestehen vorzugsweise aus kleinen Kupferdrähten, können aber auch aus Kohlefasern bestehen. Nach der Art einer Flaschenbürste kann das Anschlussteil 52 aus miteinander verdrillten Drähten hergestellt sein.

Figur 14 zeigt eine perspektivische Darstellung eines piezo-elektrischen Bauelements, wobei die verschiedenen Pole durch zwei verschiedene Hohlräume mittels einer Anordnung gemäß Figur 13 kontaktiert werden. Das linke Loch in dem Stack zeigt die Kontaktvorrichtung 5, wie sie gerade in das Loch eingeschoben wird. Das rechte Loch in dem Piezo-Stack zeigt die Kontaktvorrichtung 5, wie sie vollständig in das entsprechende Loch eingeschoben ist. Es ragt lediglich das Anschlussteil 52 aus dem Loch heraus. Mittels des Anschlussteils 52 kann die weitere Kontaktierung vonstatten gehen.

In allen Ausführungsformen, die in den Figuren gezeigt sind, gilt, dass die Federkraft entsteht durch das Einschieben der Kontaktvorrichtung 5 in den Hohlraum bzw. in das Loch. In den meisten Fällen ist ein zentrales Anschlussteil 52 vorgesehen, das durch Kontaktfedern 53 von der Wand 8 des Hohlraums 3 beabstandet ist. Durch das Einschieben des Anschlussteils bzw. durch das Einschieben einer Gesamtheit von Anschlussteil 52 und Kontaktfeder 53 entsteht eine radial gerichtete Federkraft, die einen elektrischen Kontakt zwischen dem Anschlussteil und der Kontaktfläche 4 bzw. der Innenwand der Abdeckung 7 erzeugt.

Die Herstellung einer hier beschriebenen elektrischen Funktionseinheit kann beispielsweise folgendermaßen durchgeführt werden. Es wird ein Rohr, im Falle einer Kupfer-PiezoKeramik, vorzugsweise aus Kupfer oder auch aus einer Kupferlegierung, in eine Bohrung bzw. ein zylindrisches Loch in das grüne Bauteil eingesetzt. Das Einsetzen des Rohres geschieht also vor dem Sintern des grünen Bauteils. Das grüne Bauteil wird hergestellt durch Übereinanderstapeln und Laminieren von keramischen Schichten, die eine piezo-elektrische Keramik enthalten.

Das Loch in dem grünen Bauteil kann entweder dadurch erzeugt werden, dass gestanzte Folien übereinandergestapelt werden. Das Loch kann aber auch nach dem Herstellen des Grünkörpers durch Bohren, auf einer Fräsmaschine, mittels Laser oder auch mittels eines Wasserstrahls, erzeugt werden. Anschließend wird das grüne Bauteil entkohlt und gesintert, wodurch durch den Sinterschrumpf eine gute mechanische Verbindung zwischen der Außenwand des Rohres und dem Keramikmaterial des Bauteils entsteht. Gleichzeitig entsteht eine gute elektrische Verbindung zwischen dem Rohr und den Elektrodenschichten.

Nach erfolgter Sinterung wird in dem Hohlraum im Inneren des Rohres eine Kontaktvorrichtung eingesetzt. Diese Kontaktvorrichtung kann in unterschiedlicher Art und Weise ausgeführt sein. Es sollte jedoch gewährleistet sein, dass durch eine geeignete Materialkombination für einen guten elektrischen Kontakt mittels der erzeugten Anpresskraft gesorgt wird. Ferner sollte dafür gesorgt werden, dass die federnde Kraft, die den elektrischen Kontakt erzeugt, auch bei den typischen Betriebstemperaturen zwischen 100° C und 150° C bzw. gegebenenfalls auch 180° C aufrechterhalten bleibt.

Während des Betriebs ist es möglich, dass das die Abdeckung 7 bildende Rohr bricht. Dies beeinträchtigt jedoch die Funktion des Piezoaktors nicht, da durch die Kontaktvorrichtung jedes Segment des gebrochenen Rohres sicher kontaktiert wird.

Die hier beschriebene Kontaktierung von innen hat den Vorteil, dass die Metallisierung der inneren Wand des Hohlraums bzw. Loches in beliebiger Wandstärke hergestellt werden kann, wodurch auch eine hohe mechanische Festigkeit und eine geringe Empfindlichkeit gegen mechanischen Abrieb erzeugt werden kann. Ferner kann die Abdeckung der Innenwand auch nachbearbeitet werden. Es wird dadurch eine hohe Vielzahl von verschiedenen Kontaktierungsmethoden ermöglicht.

Gefügeveränderungen und Änderungen der mechanischen Eigenschaften des Rohrmaterials und eventuell entstehende Risse im Rohr beeinflussen die Funktion der so hergestellten Funktionseinheit nur unwesentlich. Die Haftung des Rohres ist durch das Einsintern am Keramikmaterial sehr gut, sodass es wahrscheinlicher ist, dass das Rohr eher in einzelne Elemente zerbricht, als dass es sich von der Innenwand des Loches löst.

In das Innere des Rohres können Elemente zur Stromzuführung und gegebenenfalls auch zur Erzeugung einer mechanischen Vorspannung für ein piezoelektrisches Bauelement eingeführt werden.

Da diese Kontakt- bzw. Vorspannelemente erst nach dem Sintern eingebracht werden, besteht hier eine große Freiheit bezüglich der Materialauswahl und der Art der Kontaktierung.

Bezugszeichenliste

| | |
|---|---|
| 1 | Körper |
| 2 | keramische Schicht |
| 3 | Hohlraum |
| 4 | Kontaktfläche |
| 5 | Kontaktvorrichtung |
| 51 | Anschlussabschnitt |
| 52 | Anschlussteil |
| 53 | Kontaktfeder |
| 6 | elektrisches Funktionselement |
| 611, 612 | Elektrodenschichten |
| 7 | Abdeckung |
| 8 | Wand |
| 9 | Längsschlitz |
| 10 | Draht |
| 11 | Lasche |
| 12 | Litze |
| 13 | Borste |
| D | Lochdurchmesser |
| DA | laterale Ausdehnung |
| DS | Stiftdurchmesser |
| H | Steigung der Wendel |
| A | Öffnung der Wendel |
| B | Breite der Wendel |
| L | Länge des Aktors nach dem Sintern |
| L0 | Länge des Aktors vor dem Sintern |

**Patentansprüche**

1. Elektrische Funktionseinheit

   - mit einem Körper (1), der gebildet ist aus einem Stapel von übereinander liegenden keramischen Schichten (2),
   - bei der der Körper (1) einen von außen zugänglichen Hohlraum (3) enthält, an dessen Wand (8) eine Kontaktfläche (4) angeordnet ist,
   - mit einer Kontaktvorrichtung (5) zur Kontaktierung der Kontaktfläche (4), die außerhalb des Körpers (1) anschließbar ist und die ein Anschlussteil (52) und eine Kontaktfeder (53) umfasst,
   - wobei die Kontaktfeder (53) zwischen dem Körper (1) und dem Anschlussteil (52) angeordnet ist,
   **dadurch gekennzeichnet,**
   **dass** die Kontaktfeder (53) auf die Kontaktfläche (4) und das Anschlussteil (52) eine Federkraft ausübt.

2. Funktionseinheit nach Anspruch 1, bei der die Kontaktfläche (4) mit einem im Inneren des Körpers (1) angeordneten elektrischen Funktionselement (6) verbunden ist.

**3.** Funktionseinheit nach einem der Ansprüche 1 oder 2,
bei der die Kontaktfläche (4) gebildet ist durch eine Abdeckung (7), die die Wand (8) des Hohlraums (3) wenigstens teilweise bedeckt.

**4.** Funktionseinheit nach einem der Ansprüche 1 bis 3,
bei der das Anschlussteil (52) als ein aus dem Hohlraum (3) herausragender Stift ausgebildet ist.

**5.** Funktionseinheit nach Anspruch 3,
bei der die Abdeckung (7) ein metallisches Blech ist.

**6.** Funktionseinheit nach Anspruch 3,
bei der die Abdeckung (7) aus einer metallhaltigen Einbrennpaste gebildet ist.

**7.** Funktionseinheit nach Anspruch 3,
bei der die Abdeckung (7) durch einen Leitkleber gebildet ist.

**8.** Funktionseinheit nach Anspruch 3,
bei der die Abdeckung (7) gebildet ist durch einen schraubenförmig gewendelten Draht (10).

**9.** Funktionseinheit nach einem der Ansprüche 1 bis 8,
bei der die Kontaktvorrichtung (5) durch ein in Längsrichtung geschlitztes, federndes Rohr gebildet ist.

**10.** Funktionseinheit nach Anspruch 4,
bei der das Anschlussteil (52) ein Metallstift ist.

**11.** Funktionseinheit nach Anspruch 4,
bei der das Anschlussteil (52) aus miteinander verdrillten Drähten gebildet ist.

**12.** Funktionseinheit nach einem der Ansprüche 1 bis 11,
bei der die Kontaktfeder (53) gebildet ist durch ein gebogenes, federndes Blech.

**13.** Funktionseinheit nach einem der Ansprüche 1 bis 11,
bei der die Kontaktfeder (53) gebildet ist durch ein Rohr mit einer gewellten Wand.

**14.** Funktionseinheit nach einem der Ansprüche 1 bis 11,
bei der die Kontaktfeder (53) gebildet ist durch die Borsten (13) einer Rohrbürste.

**15.** Funktionseinheit nach einem der Ansprüche 1 bis 11,
bei der die Kontaktfeder (53) gebildet ist durch ein Drahtgeflecht.

**16.** Funktionseinheit nach Anspruch 2,
bei der als Funktionselemente (6) eine Vielzahl von Elektrodenschichten (611, 612) im Körper (1) enthalten sind.

**17.** Funktionseinheit nach einem der Ansprüche 3 bis 16,
bei der die Abdeckung (7) in dem Hohlraum (3) eingesintert ist.

**18.** Funktionseinheit nach einem der Ansprüche 1 bis 17,
die im Betrieb mechanische Spannungen erzeugt.

**19.** Funktionseinheit nach einem der Ansprüche 3 bis 18,
bei der der Hohlraum (3) ein im Körper (1) verlaufendes Loch ist und bei der die Abdeckung (7) ein an die Form angepasstes Rohr ist.

**20.** Funktionseinheit nach Anspruch 19,
bei der das Rohr durch die sinterschwundbedingten, zum Lochinneren gerichteten Kräfte gehalten ist.

**21.** Funktionseinheit nach einem der Ansprüche 19 bis 20,
bei der das Material des Rohres gleich dem Material der Elektrodenschichten (611, 612) ist.

**22.** Funktionseinheit nach einem der Ansprüche 19 bis 21,
bei der das Rohr ein geschlitztes, poröses, gelochtes oder mit Dellen versehenes Rohr ist.

**23.** Verfahren zur Herstellung einer elektrischen Funktionseinheit gemäß Anspruch 1 mit folgenden Schritten:

a) Bilden eines Stapels von übereinander liegenden keramischen Grünfolien, wobei der Stapel ein von außen zugängliches Loch aufweist,
b) Einführen einer Abdeckung (7) in das Loch, zur Bildung eines Hohlraums (3),
c) Sintern des Stapels gemeinsam mit der Abdeckung (7), wobei die Abdeckung (7) eine Kontaktfläche (4) bildet,
d) Einbringen einer Kontaktvorrichtung (5) in den Hohlraum (3), wobei die Kontaktvorrichtung (5) ein Anschlussteil (52) und eine Kontaktfeder (53) umfasst,
**dadurch gekennzeichnet,**
**dass** die Kontaktfeder (53) auf die Kontaktfläche (4) und das Anschlussteil (52) eine Federkraft ausübt.

**24.** Verfahren nach Anspruch 23,
wobei Schritt a) folgendermaßen durchgeführt wird:

i) Bereitstellen einer Vielzahl von keramischen Grünfolien, die mit gestanzten Durchbrüchen versehen sind,

ii) Übereinanderstapeln der Grünfolien, sodass Durchbrüche deckungsgleich übereinander zu liegen kommen und so das Loch bilden.

25. Verfahren nach Anspruch 23,
wobei das Loch in den aus Grünfolien gebildeten Stapel gebohrt wird.

26. Verfahren nach Anspruch 23,
wobei als Abdeckung (7) ein Rohr verwendet wird, dessen laterale Ausdehnung so gewählt wird, dass das Rohr durch Schrumpfen des Lochs während des Sinterns im Loch gehalten wird.

**Claims**

1. Electrical functional unit

   - having a body (1) which is formed from a stack of ceramic layers (2) located one on top of the other
   - in which the body (1) contains an externally accessible cavity (3) on whose wall (8) a contact surface (4) is arranged,
   - having a contact apparatus (5) for making contact with the contact surface (4), which contact apparatus (5) can be connected outside the body (1) and comprises a connecting part (52) and a contact spring (53),
   - wherein the contact spring (53) is arranged between the body (1) and the connecting part (52), **characterized**
   **in that** the contact spring (53) exerts a spring force on the contact surface (4) and on the connecting part (52).

2. Functional unit according to Claim 1,
wherein the contact surface (4) is connected to an electrical functional element (6) which is arranged in the interior of the body (1).

3. Functional unit according to one of Claims 1 or 2,
wherein the contact surface (4) is formed by a cover (7) which at least partially covers the wall (8) of the cavity (3).

4. Functional unit according to one of Claims 1 to 3,
wherein the connecting part (52) is in the form of a pin which projects out of the cavity (3).

5. Functional unit according to Claim 3,
wherein the cover (7) is a metallic sheet.

6. Functional unit according to Claim 3,
wherein the cover (7) is formed from a baked paste which contains metal.

7. Functional unit according to Claim 3,
wherein the cover (7) is formed by a conductive adhesive.

8. Functional unit according to Claim 3,
wherein the cover (7) is formed by a helical wire (10).

9. Functional unit according to one of Claims 1 to 8,
wherein the contact apparatus (5) is formed by a sprung tube which is slotted in the longitudinal direction.

10. Functional unit according to Claim 4,
wherein the connecting part (52) is a metal pin.

11. Functional unit according to Claim 4,
wherein the connecting part (52) is formed from wires which are twisted with one another.

12. Functional unit according to one of Claims 1 to 11,
wherein the contact spring (53) is formed by a curved, sprung metal sheet.

13. Functional unit according to one of Claims 1 to 11,
wherein the contact spring (53) is formed by a tube with a corrugated wall.

14. Functional unit according to one of Claims 1 to 11,
wherein the contact spring (53) is formed by the bristles (13) of a pipe brush.

15. Functional unit according to one of Claims 1 to 11,
wherein the contact spring (53) is formed by a wire mesh.

16. Functional unit according to Claim 2,
wherein a multiplicity of electrode layers (611, 612) are contained in the body (1) as functional elements (6).

17. Functional unit according to one of Claims 3 to 16,
wherein the cover (7) is sintered in the cavity (3).

18. Functional unit according to one of Claims 1 to 17,
which produces mechanical stresses during operation.

19. Functional unit according to one of Claims 3 to 18,
wherein the cavity (3) is a hole which runs in the body (1), and wherein the cover (7) is a tube matched to the shape.

20. Functional unit according to Claim 19,
wherein the tube is held by the forces which are directed towards the hole interior and are produced by the sintering shrinkage.

21. Functional unit according to one of Claims 19 or 20, wherein the material of the tube is the same as the material of the electrode layers (611, 612).

22. Functional unit according to one of Claims 19 to 21, wherein the tube is a slotted, porous, perforated tube, or a tube provided with indentations.

23. Method for production of an electrical functional unit according to Claim 1 having the following steps:

   a) formation of a stack of ceramic green films which are located one on top of the other, with the stack having an externally accessible hole,
   b) insertion of a cover (7) into the hole, in order to form a cavity (3),
   c) sintering of the stack together with the cover (7), with the cover (7) forming a contact surface (4),
   d) insertion of a contact apparatus (5) into the cavity (3), with the contact apparatus (5) comprising a connecting part (52) and a contact spring (53),
   **characterized**
   **in that** the contact spring (53) exerts a spring force on the contact surface (4) and on the connecting part (52).

24. Method according to Claim 23, wherein step a) is carried out as follows:

   i) provision of a multiplicity of ceramic green films which are provided with stamped apertures,
   ii) stacking of the green films one on top of the other, such that apertures are located coincidently one on top of the other, thus forming the hole.

25. Method according to Claim 23, wherein the hole is drilled into the stack formed from green films.

26. Method according to Claim 23, wherein a tube whose lateral extent is chosen such that the tube is held in the hole by shrinkage of the hole during the sintering process is used as the cover (7).

**Revendications**

1. Unité fonctionnelle électrique qui présente

   - un corps (1) formé d'une pile de couches céramiques (2) placées les unes au-dessus des autres,
   - le corps (1) contenant une cavité (3) accessible de l'extérieur et sur la paroi (8) de laquelle est disposée une surface de contact (4),
   - un dispositif de contact (5) qui assure le contact avec la surface de contact (4), qui peut être raccordé de l'extérieur du corps (1) et qui comporte une pièce de raccordement (52) et un ressort de contact (53),
   - le ressort de contact (53) étant disposé entre le corps (1) et la pièce de raccordement (52),
   **caractérisée en ce que**
   le ressort de contact (53) exerce une force élastique sur la surface de contact (4) et la pièce de raccordement (52).

2. Unité fonctionnelle selon la revendication 1, dans laquelle la surface de contact (4) est reliée à un élément fonctionnel électrique (6) disposé à l'intérieur du corps (1).

3. Unité fonctionnelle selon l'une des revendications 1 ou 2, dans laquelle la surface de contact (4) est formée par un couvercle (7) qui recouvre au moins une partie de la paroi (8) de la cavité (3).

4. Unité fonctionnelle selon l'une des revendications 1 à 3, dans laquelle la pièce de raccordement (52) est configurée comme tige qui déborde hors de la cavité (3).

5. Unité fonctionnelle selon la revendication 3, dans laquelle le couvercle (7) est une tôle métallique.

6. Unité fonctionnelle selon la revendication 3, dans laquelle le couvercle (7) est formé d'une pâte métallisée de cuisson.

7. Unité fonctionnelle selon la revendication 3, dans laquelle le couvercle (7) est formé d'un adhésif conducteur.

8. Unité fonctionnelle selon la revendication 3, dans laquelle le couvercle (7) est formé d'un fil (10) torsadé en spirale.

9. Unité fonctionnelle selon l'une des revendications 1 à 8, dans laquelle le dispositif de contact (5) est formé d'un tube élastique fendu dans le sens de sa longueur.

10. Unité fonctionnelle selon la revendication 4, dans laquelle la pièce de raccordement (52) est une tige métallique.

11. Unité fonctionnelle selon la revendication 4, dans laquelle la pièce de raccordement (52) est formée de plusieurs fils torsadés les uns avec les autres.

12. Unité fonctionnelle selon l'une des revendications 1 à 11, dans laquelle le ressort de contact (53) est formé d'une tôle élastique cintrée.

**13.** Unité fonctionnelle selon l'une des revendications 1 à 11, dans laquelle le ressort de contact (53) est formé d'un tube à paroi ondulée.

**14.** Unité fonctionnelle selon l'une des revendications 1 à 11, dans laquelle le ressort de contact (53) est formé des brosses (13) d'une brosse tubulaire.

**15.** Unité fonctionnelle selon l'une des revendications 1 à 11, dans laquelle le ressort de contact (53) est formé d'un treillis de fils.

**16.** Unité fonctionnelle selon la revendication 2, dans laquelle le corps (1) contient plusieurs couches d'électrode (611, 612) qui servent d'éléments fonctionnels (6).

**17.** Unité fonctionnelle selon l'une des revendications 3 à 16, dans laquelle le couvercle (7) est fritté dans la cavité (3).

**18.** Unité fonctionnelle selon l'une des revendications 1 à 17, qui exerce des contraintes mécaniques en fonctionnement.

**19.** Unité fonctionnelle selon l'une des revendications 3 à 18, dans laquelle la cavité (3) est un trou qui s'étend dans le corps (1) et dans laquelle le couvercle (7) est un tube adapté à sa forme.

**20.** Unité fonctionnelle selon la revendication 19, dans laquelle le tube est maintenu par des forces orientées vers l'intérieur du trou et provoquées par le retrait au frittage.

**21.** Unité fonctionnelle selon l'une des revendications 19 à 20, dans laquelle le matériau du tube est identique au matériau des couches d'électrode (611, 612).

**22.** Unité fonctionnelle selon l'une des revendications 19 à 21, dans laquelle le tube est un tube fendu, poreux, perforé ou doté de bosses.

**23.** Procédé de fabrication d'une unité fonctionnelle électrique selon la revendication 1, le procédé présentant les étapes suivantes :

a) formation d'une pile de feuilles céramiques crues disposées les unes au-dessus des autres, la pile présentant un trou accessible depuis l'extérieur,
b) insertion d'un couvercle (7) dans le trou pour former une cavité (3),
c) frittage de la pile en même temps que le couvercle (7), le couvercle (7) formant une surface de contact (4),
d) insertion d'un dispositif de contact (5) dans la cavité (3), le dispositif de contact (5) comportant une pièce de raccordement (52) et un ressort de contact (53), **caractérisé en ce que** le ressort de contact (53) exerce une force élastique sur la surface de contact (4) et sur la pièce de raccordement (52).

**24.** Procédé selon la revendication 23, dans lequel l'étape a) est exécutée de la manière suivants :

i) préparation de plusieurs feuilles céramiques crues dans laquelle une perforation est estampée,
ii) empilement des feuilles crues de telle sorte que les perforations viennent se placer les unes au-dessus des autres pour ainsi former le trou.

**25.** Procédé selon la revendication 23, dans lequel le trou est foré dans la pile formée des feuilles crues.

**26.** Procédé selon la revendication 23, qui utilise comme couvercle (7) un tube dont l'extension latérale est sélectionnée de telle sorte que le tube soit maintenu dans le trou par le retrait du trou pendant le frittage.

FIG 1

FIG 2

FIG 2A

## FIG 3

## FIG 4

## FIG 5

FIG 6

FIG 7

FIG 8

FIG 9

# FIG 10

# FIG 11

# FIG 12

## FIG 13

## FIG 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03094252 A
- JP 03151677 A

- US 4471256 A